Europäisches Patentamt

European Patent Office.

Office européen des brevets

(19)

(11) Veröffentlichungsnummer: **0 026 380**
**B1**

(12) **EUROPÄISCHE PATENTSCHRIFT**

(45) Veröffentlichungstag der Patentschrift: **21.01.87**

(51) Int. Cl.⁴: **H 01 L 27/14, H 04 N 3/14**

(21) Anmeldenummer: **80105481.8**

(22) Anmeldetag: **12.09.80**

(54) Verfahren zur zeilenweisen Abtastung eines kontinuierlich bewegten Bildes unter Abtastung von Tilebildern nach dem Zeilensprungverfahren.

(30) Priorität: **28.09.79 DE 2939518**

(43) Veröffentlichungstag der Anmeldung:
**08.04.81 Patentblatt 81/14**

(45) Bekanntmachung des Hinweises auf die Patenterteilung:
**21.01.87 Patentblatt 87/04**

(84) Benannte Vertragsstaaten:
**BE FR GB IT NL**

(56) Entgegenhaltungen:
**FR-A-2 367 353**
**GB-A-1 464 391**
**US-A-3 845 295**
**US-A-3 971 065**
**US-A-4 087 833**

**PATENTS ABSTRACTS OF JAPAN, Band 3, Nr. 132(E-149), 6. November 1979, Seite 115E149**

(73) Patentinhaber: **Siemens Aktiengesellschaft Berlin und München**
**Wittelsbacherplatz 2**
**D-8000 München 2 (DE)**

(72) Erfinder: **Herbst, Heiner, Dr.**
**Anechostrasse 29 a**
**D-8000 München 82 (DE)**
Erfinder: **Niemeyer, Matthias, Dipl.-Phys.**
**Clemensstrasse 12**
**D-8000 München 40 (DE)**

Courier Press, Leamington Spa, England.

## Beschreibung

Die Erfindung bezieht sich auf ein Verfahren zur zeilenweisen Abtastung eines kontinuierlich bewegten Bildes unter Abtastung von Teilbildern nach dem Zeilensprungverfahren.

Aus der GB—A—14 64 391 ist eine monolithisch integrierte Schaltung zur zeilenweisen Bildabtastung mit einem eine Reihe von optoelektronischen Sensorelementen aufweisenden Bildsensor bekannt, bei der die Sensorelemente über ein Transfergate an eine Auslese-CTD-Anordnung ankoppelbar sind, bei der ein Überlauf-Gate und ein Überlauf-Draingebiet neben der Reihe der Sensorelemente angeordnet sind und bei der das Überlauf-Gate mit einer Taktimpulsspannungsquelle verbunden ist, die zwischen einem einer Überlauf-Potentialbarriere entsprechenden unteren Spannungswert und einem oberen Spannungswert alterniert. Dabei wird die Integrationszeit der Sensorelemente durch eine entsprechende Ansteuerung des Überlauf-Gate variiert, um die Lichtempfindlichkeit des Bildsensors an die Intensität des einfallenden Lichts anzupassen.

Weitere monolithisch integrierte Schaltungen zur zeilenweisen Abtastung, die lineare Bildsensoren enthalten, sind aus den "IEEE Transactions on Electron Devices", Vol. ED-25, No. 2, Febr. 1978, S. 125—131 und dem BBC Report RD 1973/32 (PH. 113) "Solid State Sensors; The Use Of A Single Dimension 512 Element Array For Film Scanning", herausgegeben im November 1973 von der British Broadcasting Corp. S. 1—17 bekannt. In der letztgenannten Druckschrift wird St 1 Sti/19.12.1985 die Abtastung der Bilder eines kontinuierlich bewegten 8 mm Films angegeben, die ein die Bildinformation enthaltendes Fernsehsignal liefert.

Bei einer Bildabtastung mit den vorstehend erwähnten bekannten Schaltungen werden die einzelnen aufeinanderfolgenden Integrationszeiten, so weit sie nicht aus Gründen einer Anpassung der Lichtempfindlichkeit der Sensorelemente an das einfallende Licht verkürzt werden, durch eine dem Transfergate oder den Sensorelementen anliegende Taktimpulsspannung so gesteuert, daß sie praktisch aneinandergrenzen. Daraus ergibt sich aber, daß bei einer Abtastung nach dem sog. Zeilensprungverfahren die abgeleiteten Sensorsignale nicht den Bildinformationen der ersten, dritten, fünften Zeile usw. entsprechen, sondern der ersten einschließlich eines Teils der zweiten Zeile, der dritten einschließlich eines Teils der vierten Zeile usw.. Durch die in den gewünschten Zeilensignalen enthaltenen unerwünschten Anteile der jeweils dazwischenliegenden Zeilen wird die Auflösung des aus den Teilbildern wieder zusammengesetzten Bildes in vertikaler Richtung erheblich verschlechtert.

Der Erfindung liegt die Aufgabe zugrunde, ein Verfahren der eingangs genannten Art anzugeben, das eine Abtastung von Teilbildern gestattet, ohne daß dabei die vorstehend erwähnten Schwierigkeiten auftreten Diese Aufgabe wird durch die im Patentanspruch 1 angegebenen Merkmale gelöst.

Der mit der Erfindung erzielbare Vorteil liegt insbesondere darin, daß durch eine über das Überlauf-Gate erfolgende Steuerung der Integrationszeiten bei einer Abtastung von Teilbildern Überlappungen zwischen den Bildinformationen einer Zeile des ersten Teilbildes und eine jeweils benachbarten Zeile des zweiten Teilbildes und die damit verbundene Verschlechterung der Bildauflösung senkrecht zur Zeilenrichtung vermieden werden.

Bei der oben erwähnten Schaltung aus den 'IEEE Transactions ist zwar ebenfalls eine Steuerung der Integrationszeiten der Sensorelemente vorgesehen, doch erfolgt sie dort zum Zwecke einer Anpassung der Integrationszeiten an unterschiedliche Belichtungsintensitäten im Sinne einer "elektronischen Blende". Diese Steuerung erfolgt über ein zusätzlich vorgesehenes Gate, das den Halbleiterbereich zwischen einer Reihe von Fotodioden, die als Sensorelemente dienen, und diesen zugeordneten Speicherkondensatoren überdeckt.

Die Erfindung wird nachfolgend anhand der Zeichnung näher erläutert. Dabei zeigt:

Fig. 1 eine erste Schaltung zur Durchführung des erfindungsgemäßen Verfahrens,

Fig. 2 einen Querschnitt durch die Schaltung nach Fig. 1,

Fig. 3 Spannungs-Zeit-Diagramme zur Erläuterung der Schaltung nach Fig. 1,

Fig. 4 eine zweite Schaltung zur Durchführung des erfindungsgemäßen Verfahrens,

Fig. 5 Spannungs-Zeit-Diagramme zur Erläuterung der Schaltung nach Fig. 4,

Fig. 6 eine dritte Schaltung zur Durchführung des erfindungsgemäßen Verfahrens, und

Fig. 7 Spannungs-Zeit-Diagramme zur Erläuterung von Fig. 6.

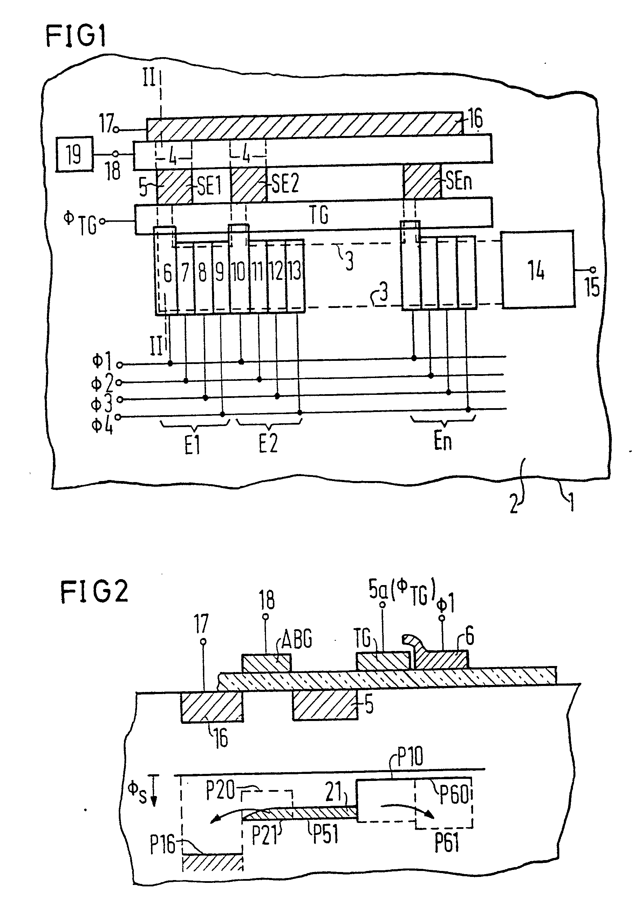

In Fig. 1 ist ein linearer Bildsensor auf einem dotierten Halbleiterkörper 1, z.B. aus p-leitendem Silizium, aufgebaut. Der Halbleiterkörper 1 ist mit einer elektrisch isolierenden Schicht 2, z.B. aus $SiO_2$, bedeckt, die innerhalb von gestrichelt gezeichneten Begrenzungslinien 3, 4 liegende Dünnschichtbereiche und außerhalb derselben liegende Dickschichtbereiche aufweist. Im Falle einer $SiO_2$-Schicht werden die ersteren auch als Gateoxidbereiche bezeichnet, die letzteren als Feldoxidbereiche. Die aus Fotodioden bestehenden Sensorelement SE1 ... SEn des Bildsensors werden durch an der Grenzfläche des Halbleiterkörpers 1 liegende, umdotierte, z.B. n-leitende, Gebiete 5 gebildet. Der die Gebiete 5 umfassende lichtempfindliche Bereich der Schaltung wird durch Öffnungen in einer die gesamte übrige Anordnung abdeckenden Metallschicht begrenzt.

Neben der Reihe der Sensorelemente SE1 ... SEn ist ein Transfergate TG angeordnet, das durch die isolierende Schicht 2 von der Grenzfläche des Halbleiterkörpers 1 getrennt ist und über einen Anschluß mit einer Taktimpulsspannung $\emptyset_{TG}$ beschaltet ist. Neben dem Transfergate TG sind die Transferelektroden einer im 4-Phasen-Betrieb arbeitenden Auslese-CTD-Anordnung vorgesehen, die einen durch die gestrichelten Linien 3 seitlich begrenzten CTD-Übertragungskanal überdecken. Die mit 6 bis 9 bezeichneten Transferelektroden sind über ihre Anschlüsse mit den Taktimpulsspannungen $\emptyset 1$ bis $\emptyset 4$ beschaltet und bilden somit ein CTD-Element E1. Die nächsten Transferelektroden 10 bis 13, die das CTD-Element E2 bilden, und die weiteren, nur teilweise dargestellten Transferelektroden sind ebenfalls mit $\emptyset 1$ bis $\emptyset 4$ beschaltet. Dem n'ten CTD-Element En schließt sich eine CTD-Ausgangsstufe 14 an, die mit einem Anschluß 15 versehen ist. Die Transferelektroden 6, 10 und die entsprechenden Elektroden der übrigen CTD-Elemente überlappen die Randzonen des Transfergate TG geringfügig und sind von diesem durch eine Zwischenisolierschicht getrennt.

Auf der von TG abgewandten Seite der Sensorelemente SE1 . . . SEn ist ein Überlauf-Gate ABG vorgesehen, das ebenfalls durch die isolierende Schicht 2 von der Grenzfläche des Halbleiterkörpers 1 getrennt ist. Neben diesem befindet sich ein der Grenzfläche von 1 anliegendes, umdotiertes, z.B. n-leitendes, Überlauf-Draingebiet 16, das über seinen Anschluß 17 mit einer festen Spannung $U_{DD}$ beschaltet ist, während das Überlauf-Gate ABG über einen Anschlu 18 mit einer Taktimpulsspannungsquelle 19 verbunden ist.

Fig. 2 zeigt einen Schnitt durch die Schaltung nach Fig. 1 entlang der Linie II—II. Dabei sind die bereits anhand der Fig. 1 beschriebenen Schaltungsteile mit den dort verwendeten Bezugszeichen versehen. Unterhalb der Schaltungsteile 16, ABG, 5, TG und 6 ist der Verlauf des Oberflächenpotentials $\emptyset_s$ Halbleiterkörpers 1 eingetragen.

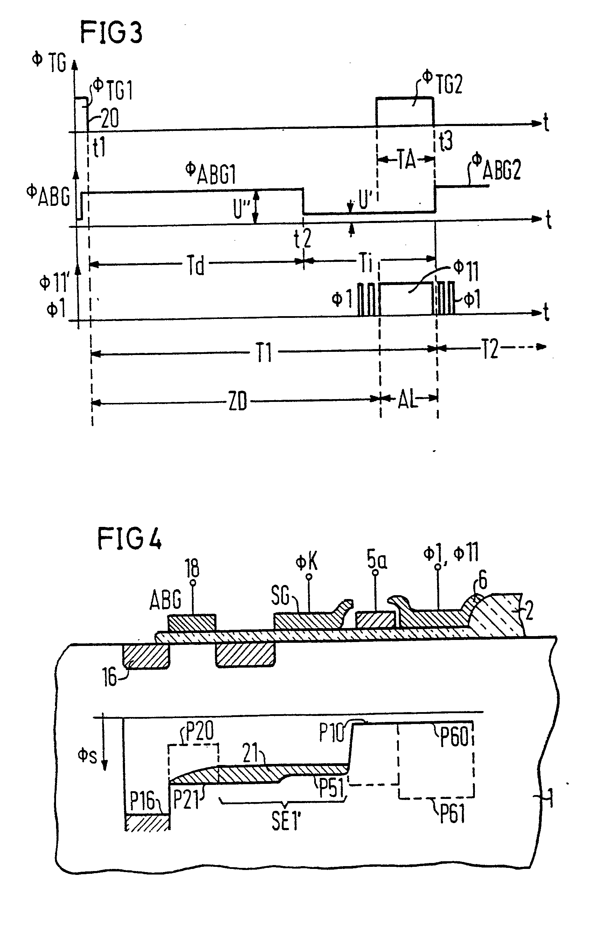

Im Betrieb beginnt ein Integrationszyklus T1 (Fig. 3) mit der Rückflanke 20 eines Taktimpulses $\emptyset_{TG1}$. Damit werden die Sensorelemente SE1 . . . SEn durch eine Potentialschwelle P10 von den Eingängen der zugeordneten CTD-Elemente E1 . . . En abgetrennt. Wegen des gleichzeitig anliegenden Taktimpulses $\emptyset_{ABG1}$ ist unterhalb des Überlauf-Gates ABG ein Potentialwert P21 vorhanden, der größer (genau so groß) ist als (wie) das Potential P51 des Gebiets 5 zu Beginn des Integrationszyklus T1. In Fig. 2 ist das zu Beginn von T1, d. h. etwa zum Zeitpunkt t1, vorhandene Potentialprofil $\emptyset_s$, das noch durch die Potentialwerte P16 des Gebiets 16 und P60 unterhalb der Transferelektrode 6 ergänzt wird, mit einer ausgezogenen Linie dargestellt. Solange der hohe Potentialwert P21 besteht, können die optisch erzeugten Ladungen, die in Fig. 2 mit der schraffierten Fläche 21 angedeutet sind, in das Gebiet 16 abfließen. Erst zum Zeitpunkt t2, d. h. beim Auftreten der Rückflanke von $\emptyset_{ABG1}$, baut sich unterhalb von ABG eine Potentialbarriere P20 auf, die einem unteren von der Taktimpulsspannungsquelle 19 gelieferten Spannungswert U' entspricht. U' ist dabei so gewählt, daß lediglich die bei zu starker Belichtung von SE auftretenden, überschüssigen Ladungsträger 21, die sonst in benachbarte Sensorelemente eindringen und die Bildinformation verfälschen würden, über P20 in das Gebiet 16 gelangen.

Zum Zeitpunkt t2 beginnt nach obigem die Integrationszeit Ti der Sensorelemente SE1 . . . SEn, in der sich optisch erzeugte Ladungsträger 21 in dem Gebiet 5 ansammeln. Beim Auftreten des Taktimpulses $\emptyset_{TG2}$ beginnt dann die Zeitspanne TA für das Auslesen der angesammelten Ladungspakete 21 in die Potentialsenke P61, die sich unter dem Einfluß eines der Transferelektrode 6 zugeführten Impulses $\emptyset 11$ gebildet hat. Parallel hierzu werden auch die anderen Sensorelemente SE2 . . . SEn in die zugehörigen CTD-Elemente ausgelesen. Die Integrationszeit Ti dauert hierbei noch an. Erst beim Auftreten der Rückflanke von $\emptyset_{TG2}$ zum Zeitpunkt t3 sind die Auslesezeit TA und die Integrationszeit Ti beendet, wobei gleichzeitig ein neuer Integrationszyklus T2 beginnt. Nach t3 werden dann die Taktimpulsspannungen $\emptyset 1$ bis $\emptyset 4$ angeschaltet, was in Fig. 3 durch einige Impulse $\emptyset 1$ angedeutet ist. Dabei werden dann die aus SE1 bis SEn ausgelesenen Ladungspakete 21, die die Bildinformationen einer ganzen Bildzeile darstellen, der Ausgangsstufe 14 sequentiell zugeführt. Diese leitet dann ein am Anschluß 15 abgreifbares Zeilensignal ab.

Die zwischen den Spannungswerten U'' (Fig. 3) und U' alternierende Taktimpulsspannungsquelle 19 bewirkt im Zeitraum t1 bis t2 beim Anliegen von U'' am Gate ABG ein Abfließen der optisch erzeugten Ladungsträger 21 aus den Sensorelementen SE1 bis SEn über das Überlauf-Gate ABG und im Zeitraum t2 bis t3 beim Anliegen von U' am Gate ABG eine sogenannte ''Anti-Blooming''-Funktion des letzteren. Die Integrationsziet Ti stellt jeweils nur einen Teilabschnitt des Integrationszyklus T1 dar, so daß zwischen zwei aufeinanderfolgenden Integrationszeiten Ti jeweils ein Zeitabschnitt Td liegt. Daher ist bei einer kontinuierlichen Bewegung eines abzutastenden Bildes zwischen jeweils zwei nacheinander ausgewerteten Bildzeilen ein durch die Länge der Impulse $\emptyset_{ABG1}$, $\emptyset_{ABG2}$ usw. bestimmter, konstanter Abstand vorhanden.

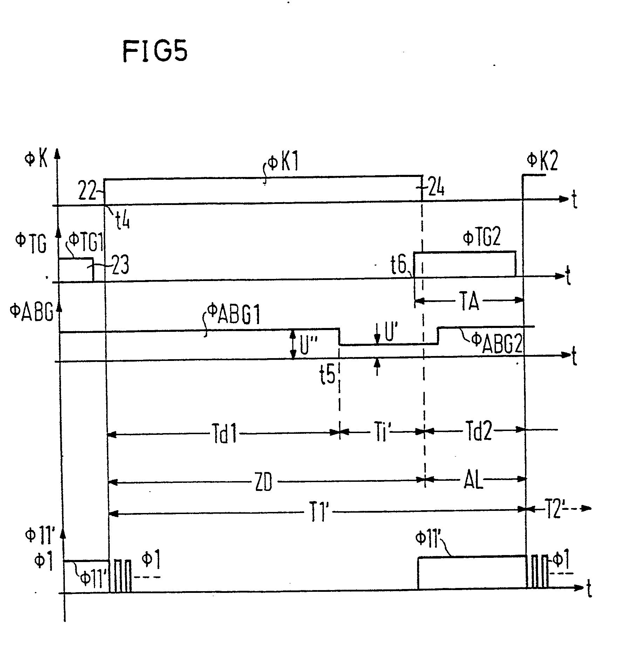

Fig. 4 zeigt eine andere Ausführungsform des Bildsensors, der sich von Fig. 1 lediglich dadurch unterscheidet, daß jedes Sensorelement, z.B. SE1', aus einer Fotodiode 5 und einem MIS-Kondensator besteht, der eine auf der isolierenden Schicht 2 angeordnete Elektrode SG aufweist. Die Elektrode SG ist über ihren Anschluß mit einer Taktimpulsspannung $\emptyset K$ beschaltet. Die bereits anhand der Figuren 1 und 2 beschriebenen Schaltungsteile sind in Fig. 4 mit den gleichen Bezugszeichen versehen. Der lichtempfindliche Bereich, der durch die Öffnungen einer die übrigen Teile der Schaltung abdeckenden lichtundurchlässigen Schicht bestimmt wird, umfaßt hierbei die Gebiete 5 und gegebenenfalls die von den transparenten Elektroden SG überdeckten Halbleiterzonen.

Die in Fig. 5 dargestellten Diagramme lassen erkennen, daß bei der Schaltung nach Fig. 4 ein Integrationszyklus T1' jeweils mit der Vorderflanke 22 eines Taktimpulses ØK1 beginnt, die zum Zeitpunkt t4 auftritt. Das hierzu gehörende Potentialprofil Ø$_s$ unterhalb der Schaltungsteile 16, ABG, 5, SG, TG und 6 ist in Fig. 4 mit ausgezogenen Linien angedeutet. Mit der Rückflanke 23 des Taktimpulses Ø$_{TG1'}$ war schon vorher das Sensorelement SE1' durch die Potentialschwelle P10 von dem Eingang des CTD-Elements unterhalb der Transferelektrode 6 abgetrennt worden. Wegen des anliegenden Taktimpulses Ø$_{ABG1'}$ mit der Amplitude U'' ist unterhalb von ABG wieder ein Potentialwert P21 vorhanden, der größer ist als das Potential P51 des unterhalb von SG liegenden Bereiches des Sensorelementes SE1' zu Beginn des Integrationszyklus. Dabei fließen optisch erzeugte Ladungen 21 wieder zum Gebiet 16 ab. Erst zum Zeitpunkt t5, d. h. beim Auftreten der Rückflanke von Ø$_{ABG1'}$, entsteht die Potentialbarriere P20, die dem Spannungswert U' entspricht. Damit beginnt die Integrationszeit, zum Zeitpunkt t5. Mit dem Taktimpuls Ø$_{TG2'}$ beginnt (t6) die Zeitspanne TA' für das Auslesen der angesammelten Ladungspakete 21 in die Potentialsenke P61, die sich wegen Ø11' unterhalb von 6 gebildet hat. Die Integrationszeit Ti' wird durch die Rückflanke 24 von ØK1 beendet. Nach dem Auftreten eines neuen Taktimpulses Ø$_{ABG2'}$ und dem Ende von Ø$_{TG2'}$ bzw. dem Ende der Auslesezeit TA' beginnt dann mit dem nächsten Impuls ØK2 ein neuer Integrationszyklus T2'. In diesem werden dann die Taktimpulsspannungen Ø1 bis Ø4 angeschaltet, wie in Fig. 5 durch Ø1 angedeutet ist, die die ausgelesenen Ladungspakete wieder zur Ausgangsstufe 14 der Auslese-CTD-Anordnung transportieren. Auch nach Fig. 5 stellt die Integrationszeit Ti' nur einen Teilabschnitt des Integrationszyklus T1' dar, wobei zwischen zwei aufeinanderfolgenden Integrationszeiten Ti' jeweils zwei Zeitabschnitte Td1 und Td2 liegen. Daher ist auch hier bei einer kontinuierlichen Bewegung eines abzutastenden Bildes zwischen zwei nacheinander ausgewerteten Bildzeilen jeweils ein konstanter Abstand vorhanden.

Die in Figur 4 dargesellte weitere Ausgestaltung der Bildsensors ergibt sich dadurch, daß die die Fotodioden darstellenden Gebiete 5 weggelassen werden, so daß die MIS-Kondensatoren mit den Elektroden SG allein die Sensorelemente SE1'... bilden. In diesem Fall müssen die Schaltungsteile ABG und 16 in Fig. 4 nach rechts verschoben werden, so daß ABG und TG einander unmittelbar benachbart sind. Die Ansteuerung dieser Schaltung entspricht Fig. 5.

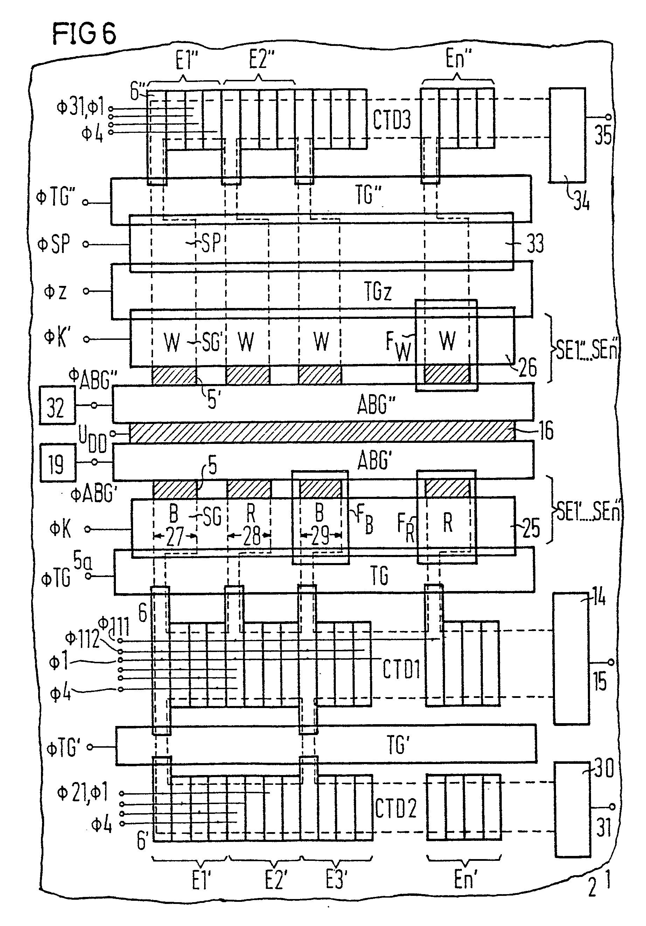

In Fig. 6 ist ein weiteres Aufführungsbeispiel der Schaltung dargestellt, bei der der lineare Bildsensor zwei parallele Reihen von Sensorelementen SE1'... SEn' und SE1''... SEn'' enthält. Jedes Sensorelement besteht aus einem umdotierten Gebiet, z.B. 5 oder 5', das eine Fotodiode darstellt, und einem MIS-Kondensator. Die MIS-Kondensatoren für sämtliche Sensorelemente einer Reihe sind jeweils aus leitenden streifenförmigen Belegungen 25 und 26 gebildet, deren oberhalb von Dünnschichtbereichen 27, 28, 29 usw. der isolierenden Schicht 2 leigende Teile jeweils die einzelnen Elektroden SG, SG' darstellen. Die Sensorelemente SE1'... SEn' der unteren Reihe sind zu zwei Gruppen zusammengefaßt, wobei die zur ersten Gruppe gehörenden mit B gekennzeichnet, sind, die zur zweiten Gruppe gehörenden mit R. Alle mit B gekennzeichneten Sensorelemente sind mit Farbfiltern erster Art abgedeckt, von denen eines durch einen Rahmen F$_B$ angedeutet ist. Alle mit R gekennzeichneten Sensorelemente sind mit Farbfiltern zweiter Art abgedeckt, die durch einen Rahmen F$_R$ angedeutet sind. Alle Sensorelement SE1''... SEn'' sind zu einer weiteren Gruppe zusammengefaßt und mit Farbfiltern dritter Art abgedeckt, die durch einen Rahmen F$_W$ angedeutet sind. Die lichtempfindlichen Bereiche der Schaltung, die durch Öffnungen einer die übrigen Schaltungsteile abdeckenden lichtundurchlässigen Schicht, bestimmt sind, umfassen wieder die Gebiete 5 und gegebenenfalls die von den Elektroden SG überdeckten Halbleiterzonen.

Die Schaltungsteile ABG', 16, 19, TG, 6, 14 und 15 entsprechen den in gleicher Weise bezeichneten Teilen der Figuren 1 und 4. Neben der Auslese-CTD-Anordnung CTD1 ist eine weitere solche Anordnung CTD2 vorgesehen, die in analoger Weise aufgebaut und deren Elemente mit E1' bis En' bezeichnet sind. Die neben den mit B bezeichneten Sensorelementen angeordneten Elemente von CTD1 weisen jeweils eine in Richtung auf CTD2 verlängerte Transferelektrode, z.B. 6, auf, die einer in Richtung auf CTD1 verlängerten Transferelektrode, z.B. 6', von CTD2 gegenübersteht. Die verlängerten Transferelektroden, z.B. 6 und 6', überlappen dabei die Randzonen eines zwischen CTD1 und CTD2 liegenden Transfergates TG' geringfügig TG' ist über einen Anschluß mit Ø$_{TG}$' beschaltet. Die Anordnung CTD2 weist eine Ausgangsstufe 30 auf, die mit einem Anschluß 31 versehen ist.

Zwischen dem Überlauf-Draingebiet 16 und der Reihe der Sensorelemente SE1''... SEn'' ist ein zweites Überlauf-Gate ABG'' vorgesehen, das mit einer Taktimpulsspannungsquelle 32 verbunden ist, die eine Taktimpulsspannung Ø$_{ABG}$'' abgibt. Neben den Kondensatoren z.B. SG', von SE1'' bis SEn'' ist ein Gate TGz, eine streifenförmige leitende Belegung 33 und ein Transfergate TG'' vorgesehen, die durch die elektrisch isolierende Schicht 2 vom Halbleiterkörper 1 getrennt sind und durch Zwischenschichten gegeneinander isoliert sind. Sie überlappen sich randseitig geringfügig und sind über ihre Anschlüsse mit den Takimpulsspannungen Ø$_z$, Ø$_{Sp}$ und Ø$_{TG}$'' beschaltet. Diejenigen Teile der leitenden Belegung 33, die oberhalb der gestrichelt eingezeichneten Dünnschichtbereiche der isolierenden Schicht 2 liegen, stellen dabei die Elektroden, z.B. SP, von Speicherkondensatoren dar, die den Sensorelementen SE1'' bis SEn'' individuell zugeordnet sind. Neben dem Transfergate TG'' ist eine dritte Auslese-CTD-Anordnung CTD3 vorgesehen, die mit Ø1 bis Ø4 beschaltete CTD-Elemente E1'' bis En'' aufweist. Jeweils eine Transferelektrode, z.B. 6'', jedes Elements, z.B. E1'', ist in Richtung auf das Transfergate TG'' soweit verlängert, daß es dasselbe randseitig geringfügig überlappt. Das CTD3 weist eine Ausgangsstufe 34 auf, die einen Anschluß 35 besitzt.

Die Farbfilter $F_B$ und $F_R$ weisen unterschiedliche spektrale Empfindlichkeitskurven auf, die beispielsweise den Grundfarben Blau und Rot entsprechen, während die Farbfilter $F_W$ Empfindlichkeitskurven aufweise, die etwa den ganzen Bereich des sichtbaren Lichts umfassen, wobei sie einen Bereich maximaler Empfindlichkeit im Spektralbereich der Grundfarbe Grün besitzen. Andererseits können aber die Farbfilter $F_W$ auch eine Empfindlichkeitskurve haben, die im Spektralbereich der Grundfarbe Grün liegt.

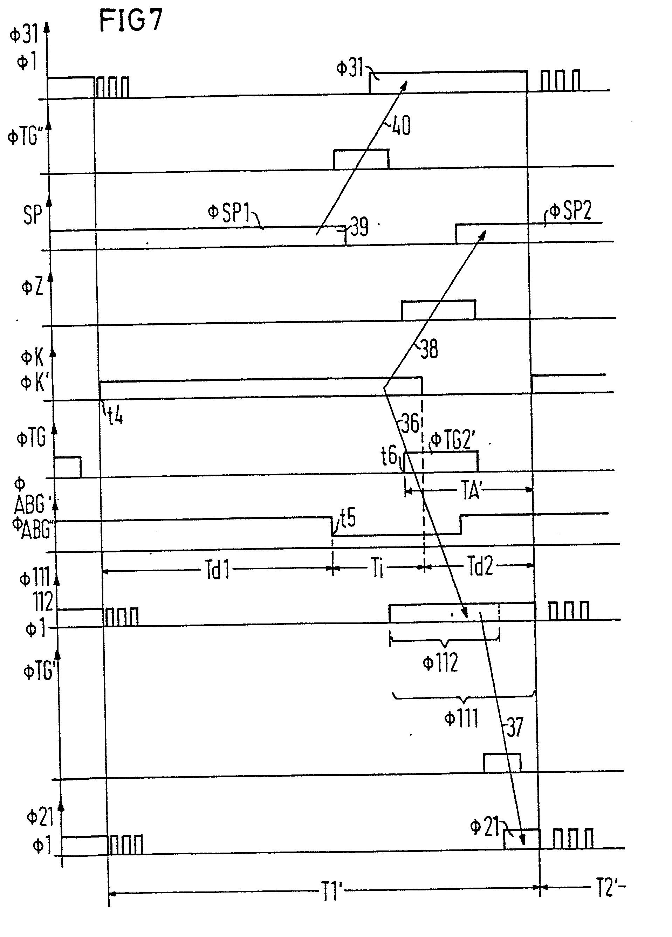

Die Betriebsweise der Schaltung nach Fig. 6 sei anhand der Fig. 7 näher erläutert. Dabei entsprechen die Diagramme für ØK, ØK', $Ø_{TG}$, $Ø_{ABG}'$, $Ø_{ABG}''$, Ø111 und Ø112 im wesentlichen der Fig. 5. Anstelle einer Taktimpulsspannung Ø11 sind jedoch zwei Spannungen Ø111 und Ø112 vorgesehen, von denen Ø111 den ersten Transferelektroden derjenigen CTD-Elemente von CTD1 zugeführt werden, die neben einem mit R bezeichneten Sensorelement angeordnet sind, während Ø112 den ersten Transferelektroden derjenigen CTD-Elemente von CTD1 zugeführt wird, die neben einem "B"-Sensorelement liegen. Während der Pfeil 36 eine Übertragung der optisch erzeugten Ladungspakete aus allen Sensorelementen SE1' ... SEn' in die entsprechenden CTD-Elemente von CTD1 kennzeichnet, bedeutet der Pfeil 37 die Weitergabe der aus den "B"-Sensorelementen stammenden Ladungspakete über gas geöffnete Transfergate TG' in die Elemente E1', E3' usw. von CTD2. Somit verbleiben nur die aus "R"-Sensorelementen stammenden Ladungspakete in jedem zweiten Element von CTD1. Andererseits bedeutet der Pfeil 38 eine Übertragung aller in den Sensorelementen SE1'' ... SEn'' optisch erzeugten Ladungspakete über das mittels $Ø_z$ geöffnete Transfergate TGz in die Speicher SP, die zu diesem Zweck mit einem Taktimpuls $Ø_{SP2}$ beschaltet sind. Schon vorher wurden die Speicher SP mit der Rückflanke 39 von $Ø_{SP1}$ über das durch einen Taktimpuls $Ø_{TG}''$ geöffnete Transfergate TG'' in die Elemente E1'' bis En'' von CTD3 ausgelesen (Pfeil 40), wobei die während des vorhergehenden, in Fig. 7 nicht dargestellten Integrationszyklus in SP zwischengespeicherten Ladungen weitergegeben wurden.

Man geht nun davon aus, daß während des vorhergehenden, in Fig. 7 nicht dargestellten Integrationszyklus eine bestimmte Bildzeile eines abzutastenden Farbbildes auf die Reihe der mit W-Filtern versehenen Sensorelemente SE1'' ... SEn'' ausgerichtet war, wobei von ihr W-bewertete Sensorsignale abgeleitet und in den Speichern SP zwischengespeichert wurden. Während des in Fig. 7 dargestellten Integrationszyklus T1' ist dann infolge der kontinuierlichen Bewegung des abzutastenden Farbbildes dieselbe Zeile auf die Reihe der Sensorelemente SE1' ... SEn' ausgerichtet, wobei von ihr B- und R-bewertete Sensorsignale abgeleitet und in die Elemente von CTD1 und CTD2 ausgelesen werden. Gleichzeitig werden aber auch die zwischengespeicherten W-bewerteten Sensorsignale aus den Speichern SP in die Elemente von CTD3 ausgelesen. Zu Beginn des Integrationszyklus T2' werden dann die Taktimpulsspannungen Ø1 bis Ø4 angeschaltet, die die W-, R- und B-bewerteten Sensorsignale bzw. Ladungspakete den Ausgangsstufen 34, 14 und 30 getrennt zuführen. In den Ausgangsstufen werden dann W-, R- und B-Spannungssignale abgeleitet, die an den Anschlüssen 35, 15 und 30 zur Verfügung stehen. Aus diesen Spannungssignalen können sogenannte Farbwertsignale abgeleitet werden, die die Helligkeiten der Grundfarben einer Farbfernsehbildröhre steuern.

Auch bei der Schaltung nach Fig. 6 ist die Integrationszeit Ti' nur ein Teilabschnitt jedes Integrationszyklus T1, so daß zwischen zwei aufeinanderfolgenden Integrationszeiten Ti jeweils konstante Zeitabschnitt Td1 und Td2 liegen, die einen konstanten Abstand jeweils zweier nacheinander ausgewerteter Bildzeilen des abzutastenden Farbbildes gewährleisten.

Bei den behandelten Ausführungsbeispielen, bei denen von einem p-leitenden Halbleiterkörper ausgegangen wird, weisen die angegebenen Potentiale und Spannungen gegenüber dem Bezugspotential der Schaltung, auf dem der Halbleiterkörper 1 liegt, jeweils positive Vorzeichen auf, Werden die Leitfähigkeitstypen der einzelnen Halbleitergebiete durch die jeweils entgegengesetzten ersetzt, so kehren sich auch die Vorzeichen der Spannungen und Potentiale um.

Obwohl die CTD-Anordnungen der angegebenen Ausführungsbeispiele als SCCD-Anordnungen (Surface-Change-Coupled Device) ausgebildet sind, kann die Erfindung mit bekannten CTD-Anordnungen beliebiger Art ausgeführt werden, wie sie z.B. in dem Buch von Sequin und Tompsett "Charge Transfer Devices", Academic Press, New York, 1975, auf den Seiten 1 bis 18 beschrieben sind. Die CTD-Anordnungen können dabei entsprechend ihrem Aufbau nach einem der bekannten Verfahren, so z.B. im 2-, 3-, 4 oder Mehrphasenbetrieb, arbeiten.

Die in den Figuren 3, 5 und 7 jeweils mit ZD bezeichneten Zeitabschnitte stellen die Zeilendauer dar.

Dies ist die Zeitspanne, in der die einer Bildzeile entsprechenden Sensorsignale unter dem Einfluß der Taktimpulsspannungen Ø1 bis Ø4 an den Ausgängen 15, 31 und 35 abgegeben werden. Sie wird zweckmäßigerweise so gewählt, daß sie der Zeitspanne entspricht, die ein durch die weiterverarbeiteten Sensorsignale gesteuerter Elektronenstrahl eines Bildsichtgeräts braucht, um eine Bildzeile zu schreiben. Innerhalb einer Zeilendauer ZD wird aus der erfindungsgemäßen Schaltung jeweils das in dem unmittelbar vorangegangenen Integrationszyklus erhaltene Zeilensignal ausgelesen. Der zwischen zwei Zeitabschnitten ZD liegende Zeitabschnitt AL wird als Austastlücke bezeichnet. In diesem Zeitabschnitt wird ein das Zeilensignal in einem Wiedergabegerät schreibender Elektronenstrahl ausgetastet und vom Zeilenende zum Zeilenanfang der nächsten Zeile hingeführt. Bei einer Wiedergabe in Fernsehgeräten müssen die Zeitabschnitte ZD und AL der Fernsehnorm entsprechen und betragen jeweils 52 μs und 12 μs.

## Patentansprüche

1. Verfahren zur zeilenweisen Abtastung eines kontinuierlich bewegten Bildes unter Abtastung von Teilbildern nach dem Zeilensprungverfahren unter Verwendung einer monolithisch integrierten Schaltung mit einem eine Reihe von optoelektronischen Sensorelementen (SE1 . . . SEn) aufweisenden Bildsensor, bei der die Sensorelemente über ein Transfergate (TG) an eine Auslese-CTD-Anordnung (3) ankoppelbar sind, bei der ein Überlauf-Gate (ABG) und ein Überlauf-Draingebiet (16) neben der Reihe der Sensorelemente angeordnet sind und bei der das Überlauf-Gate (ABG) mit einer Taktimpulsspannungsquelle (19) verbunden ist,

— bei dem einem ersten Verfahrenschritt die Taktimpulsspannungsquelle (19) dem Überlauf-Gate (ABG) einen oberen Spannungswert (U'') zuführt, der bewirkt, daß das Überlauf-Gate geöffnet ist und die Sensorelemente (SE1 . . . SEn) mit dem Überlauf-Draingebiet (16) verbunden sind,
— und bei dem in einem zweiten Verfahrensschritt die Taktimpulsspannungsquelle (19) dem Überlauf-Gate (ABG) einen unteren Spannungswert (U') zuführt, der bewirkt, daß unter dem Überlauf-Gate (ABG) eine Überlauf-Potentialbarriere besteht.

2. Verfahren nach Anspruch 1, unter Verwendung einer monolithisch ingetrierten Schaltung mit einem zwei Reihen von optoelektronischen Sensorelementen (SE1' . . . SEn', SE1'' . . . SEn'') aufweisenden Bildsensor, bei der die Sensorelemente (SE1'' . . . SEn'') der ersten Reihe zu einer ersten Gruppe (W) und die Sensorelemente (SE1' . . . SEn') der zweiten Reihe zu zwei weiteren Gruppen (B, R) zusammengefaßt sind, bei der die Sensorelemente hinter Farbfiltern (F_W, F_B, F_R) mit unterschiedlichen, gruppen-St 1 Sti/19.12.1985 spezifischen Spektralbereichen angeordnet und mit einer aus einer vorgegebenen Zahl von gruppenspezifischen Auslese-CTD-Anordnungen (CTD1, CTD2, CTD3) verbindbar sind, bei der die jeweils einer Gruppe zugeordneten Auslese-CTD-Anordnungen einen Anschluß (15, 31, 35) zum sequentiellen Auslesen sämtlicher aus dieser Gruppe (R, B, W) angeleiteten Sensorsignals aufweisen, bei der das Überlauf-Draingebiet (16) zwischen den beiden Reihen von optoelektronischen Sensorelementen angeordnet ist und bei der beiderseits des Überlauf-Draingebiets (16) jeweils ein Überlauf-Gate (ABG', ABG'') vorgesehen und mit einer Taktimpulsspannungsquelle (19, 32) verbunden ist, die zwischen einem der Überlauf-Potentialbarriere (P20) entsprechenden, unteren Spannungswert (U') und einem oberen Spannungswert (U'') alterniert.

## Revendications

1. Procédé de balayage, suivant des lignes, d'une image en mouvement continuel, avec balayage d'images partielles selon le procédé d'entrelacement, utilisant un circuit intégré monolithique comportant un capteur d'image qui présenté une rangée d'éléments capteurs optoélectroniques (SE1 . . . SEn), sur lequel les éléments capteurs sont accouplables par une porte de transfert (TG) à un dispositif CTD de lecture (3), sur lequel une porte de débordement (ABG) et une région de drain de débordement (16) sont disposées à côté de la rangée des éléments capteurs et sur lequel la porte de débordement (ABG) est connectée à une source de tension impulsionnelle d'horloge (19), procédé dans lequel,

— dans une première étape, la source de tension impulsionnelle d'horloge (19) applique à la porte de débordemente (ABG) und valeur de tension supérieure (U''), provoquant l'ouverture de la porte de débordement et la connexion des éléments capteurs (SE1 . . .SEn) à la région de drain de débordement (16) et,
— dans une deuxième étape, la source de tension impulsionnelle d'horloge (19) applique à la porte de débordement (ABG) une valeur de tension inférieure (U') qui provoque l'existence, sous la porte de débordement (ABG), d'une barrière de potentiel de débordement.

2. Procédé selon la revendication 1, utilisant un circuit intégré monolithique comportant un capteur qui présente deux rangées d'éléments capteurs optoélectroniques (SE1' . . SEn', SE1'' . . . SEn''), sur lequel les éléments capteurs (SE1'' . . . SEn'') de la première rangée sont réunis en un premier groupe (W) est les éléments capteurs (SE1' . . . SEn') de la deuxième rangée sont réunis en deux autres groupes (B, R), sur lequel les éléments capteurs sont disposés derrière des filtres chromatiques (F_W, F_B, F_R) à domaines spectraux différents, spécifiques aux groupes, et peuvent être connectés à l'un d'un nombre préfixé de dispositifs CTD de lecture spécifiques aux groupes CTD1, CTD2, CTD3), sur lequel les dispositifs CTD de lecture coordonnés à un groupe présentent une borne (15, 31, 35) pour la lecture séquentielle de tous les signaux de capteur dérivés de ce groupe (R, B, W), sur lequel la région de drain de débordement (16) est disposée entre deux rangées d'éléments capteurs optoélectroniques et sur lequel une porte de débordement (ABG', ABG'') est prévue des deux côtés de la région de drain de débordement (16) et est connectée à une source de tension impulsionnelle d'horloge (19, 32) qui alterne entre une valeur de tension inférieure (U'), correspondant à la barrière de potentiel de débordement (P20), et une valeur de tension supérieure (U'').

**Claims**

1. A method for the row-by-row scanning of a continuously moving image by scanning partial images in accordance with the line-jump method, using a monolithically integrated circuit including an image sensor which comprises a series of opto-electronic sensor elements (SE1 ... SEn), where the sensor elements can be coupled via a transfer gate (TG) to a read-CTD-arrangement (3), where an overflow gate (ABG) and an overflow drain zone (16) are arranged beside the series of sensor elements and where the overflow gate (ABG) is connected to a clock pulse voltage sources (19),

— where, in a first step, the clock pulse voltage source (19) supplies the overflow gate (ABG) with an upper voltage value (U'') which causes the overflow gate to open and the sensor elements (SE1 ... SEn) to be connected to the overflow drain zone (16),

— and where, in a second step, the clock pulse voltage source (19) supplies the overflow gate (ABG) with a lower voltage value (U') which causes an overflow potential barrier to occur beneath the overflow gate (ABG).

2. A method as claimed in claim 1, using a monolithically integrated circuit including an image sensor which comprises two series of opto-electronic sensor elements (SE1' ... SEn', SE1'' ... SEn''), where the sensor elements (SE1'' ... SEn'') of the first series are combined to form a first group (W) and the sensor elements (SE1' ... SEn') of the second series are combined to form two further groups (B, R) where the sensor elements are arranged behind colour filters ($F_W$, $F_B$, $F_R$) which have different, group-specific spectral zones and can be connected to one of a predetermined number of group-specific read-CTD-arrangement (CTD1, CTD2, CTD3), where the read-CTD-arrangements which are each assigned to a group have a terminal (15, 31, 35) for the sequential read-out of all the sensor signals derived from this group (R, B, W), where the overflow-drain zone (16) is arranged between the two series of opto-electronic sensor elements, and where an overflow gate (ABG', ABG'') is provided on both sides of the overflow drain zone (16) and is connected to a clock pulse voltage source (19, 32) which alternates between a lower voltage (U') corresponding to the overflow potential barrier (P20) and an upper voltage value (U'').

# FIG1

# FIG2

## FIG 3

## FIG 4

# FIG5

0 026 380

FIG 6

FIG 7